# EUROPEAN PATENT APPLICATION

(11) **EP 4 841 746 A1**
(43) Date of publication of application: **18.11.2026**
(21) Application number: 24916945.9
(22) Date of filing: 26.12.2024
(51) Int. Cl.: H01M 10/48, G01R 31/396, H02J 7/00

(54) **BATTERY ABNORMALITY DETECTION SYSTEM, BATTERY ABNORMALITY DETECTION METHOD, AND BATTERY ABNORMALITY DETECTION PROGRAM**

(30) Priority: 12.01.2024 JP 2024003172
(71) Applicant: Panasonic Intellectual Property Management Co., Ltd., Kadoma-shi, Osaka 571-0057 (JP)
(72) Inventor: HORI, Kunihiko, Kadoma-shi, Osaka 571-0057 (JP); TAKAO, Hiroshi, Kadoma-shi, Osaka 571-0057 (JP)
(74) Representative: Novagraaf International SA
(86) International application number: PCT/JP2024/046127
(87) International publication number: WO 2025/150443

(57) **Abstract**

An acquisition unit (341) acquires time-series data of voltage of a plurality of single cells or a plurality of parallel cell groups when an assembled battery system (31) is in a state of being charged to a target voltage or when any one of the plurality of single cells or any one of the plurality of parallel cell groups is in a state of being charged to the target voltage. A determination unit (342) determines that a micro short circuit has occurred in a single cell or a parallel cell group of which the acquired voltage when in the state of being charged to the target voltage shows a downward trend, the single cell being one of the plurality of single cells, the parallel cell group being one of the plurality of parallel cell groups.

## Description

### Technical Field

The present disclosure relates to a battery abnormality detection system, a battery abnormality detection method, and a battery abnormality detection program for detecting a micro short circuit in an assembled battery system.

### Background Art

An increasing number of devices, such as EVs and notebook PCs, are equipped with multiple battery cells connected in series (hereinafter, simply referred to as cells), and many of them use a battery pack including an assembled battery system configured by cells in multiple series and multiple parallel connections. In a case where a lithium-ion cell is used, there is a possibility of ignition when a short circuit occurs. Thus, it is necessary to find an abnormal cell at an early stage especially in a battery pack in which a lithium-ion cell is used.

In many cases, a micro short circuit of a battery pack configured by multiple parallel connections is not noticed until the voltage difference becomes large, and it is difficult to find the short circuit at an early stage. As a method of detecting an internal short circuit of a cell, it may be possible to determine that a short circuit has occurred when a voltage difference between a reference voltage calculated from an integrated current value or a state of charge (SOC) and a measured voltage of a parallel cell group exceeds a predetermined value. In addition, it may be possible to determine that a parallel cell group having a voltage difference larger than a predetermined value from another parallel cell group connected in series as a short-circuited cell (for example, see Patent Literature 1). However, the voltage between the parallel cell groups connected in series may vary due to a factor other than the internal short circuit. In this case, if the presence or absence of the internal short circuit is determined only based on the voltage difference, false detection may occur.

It also may be possible to smooth the voltages of the parallel cell groups during charging and discharging, and determine that a short circuit has occurred when the voltage difference between the parallel cell groups is equal to or greater than a predetermined value. However, in this method, it is difficult to adjust the degree of smoothing, and false detection or missed detection may occur due to insufficient smoothing or excessive smoothing.

### Citation List

### Patent Literature

Patent Literature 1: Japanese Patent Unexamined Publication No. 2011-135656

### Summary of Invention

The present disclosure has been made in view of such circumstances, and an object thereof is to provide a technique for detecting a micro short circuit of a cell with high accuracy at an early stage.

### Solution to Problem

In order to solve the above problem, a battery abnormality detection system according to an aspect of the present disclosure is a battery abnormality detection system for detecting an abnormality of an assembled battery system including a plurality of single cells connected in series or a plurality of parallel cell groups connected in series, comprising: an acquisition unit that acquires time-series data of voltage of the plurality of single cells or the plurality of parallel cell groups when the assembled battery system is in a state of being charged to a target voltage or when any one of the plurality of single cells or any one of the plurality of parallel cell groups is in a state of being charged to the target voltage; and a determination unit that determines that a micro short circuit has occurred in a single cell or a parallel cell group of which the acquired voltage when in the state of being charged to the target voltage shows a downward trend, the single cell being one of the plurality of single cells, the parallel cell group being one of the plurality of parallel cell groups.

Any selective combinations of the aforementioned constituent elements, and implementations of the disclosure in the form of devices, systems, methods, computer programs, and so forth may also be practiced as additional modes of the present disclosure.

According to the present disclosure, a micro short circuit of a cell can be detected at an early stage with high accuracy.

### Brief Description of Drawings

[Fig. 1] FIG. 1 is a diagram for explaining a battery-equipped device according to a first embodiment.
[Fig. 2A] FIG. 2A is a diagram showing a configuration of an assembled battery system including a plurality of single cells connected in series.
[Fig. 2B] FIG. 2B is a diagram showing a configuration of an assembled battery system including a plurality of parallel cell groups connected in series.
[Fig. 3] FIG. 3 is a diagram showing an example of transition data of a maximum cell voltage and a minimum cell voltage in the assembled battery system.
[Fig. 4] FIG. 4 is a diagram showing an example of transition data of the voltage of each cell after occurrence of a micro short circuit in the assembled battery system having three cells connected in series.
[Fig. 5] FIG. 5 is a diagram showing a cell voltage upon reaching full charge, which is extracted from the transition data of the cell voltage shown in FIG. 4.
[Fig. 6] FIG. 6 is a flowchart illustrating a flow of battery abnormality detection processing by a battery management device according to the first embodiment.
[Fig. 7] FIG. 7 is a diagram showing another example of a cell voltage upon reaching full charge, which is extracted from transition data of the voltage of each cell after occurrence of a micro short circuit in an assembled battery system having three cells connected in series.
[Fig. 8] FIG. 8 is a diagram for explaining a battery-equipped device according to a second embodiment.
[Fig. 9] FIG. 9 is a diagram illustrating a configuration example of a battery abnormality detection system according to the second embodiment.

### Description of Embodiments

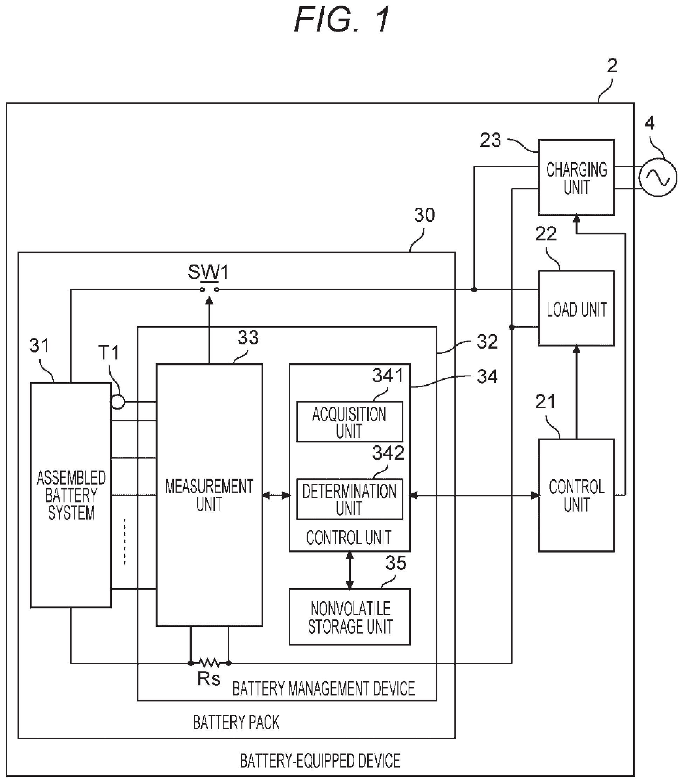

FIG. 1 is a diagram for explaining a battery-equipped device 2 according to a first embodiment. The battery-equipped device 2 according to the first embodiment is a device equipped with a chargeable and dischargeable battery pack 30. Examples of the battery-equipped device 2 include consumer information devices (e.g., PCs, tablets, and smartphones), home appliances (e.g., cleaning robots), electric cars, electric motorcycles, electric bicycles, electric kickscooters, and multicopters (drones). Hereinafter, in the present embodiment, a notebook PC is assumed.

The battery-equipped device 2 includes a control unit 21, a load unit 22, a charging unit 23, and a battery pack 30. The control unit 21 comprehensively controls the entire battery-equipped device 2. The function of the control unit 21 can be realized by cooperation of hardware resources and software resources or only hardware resources. As the hardware resources, a CPU, a ROM, a RAM, a GPU (Graphics Processing Unit), an NPU (Neural Network Processing Unit), an ASIC (Application Specific Integrated Circuit), an FPGA (Field Programmable Gate Array), and other LSIs can be used. Programs such as an operating system and applications can be used as software resources.

The load unit 22 is a general term (excluding the control unit 21 and the charging unit 23) for members that consume power in the battery-equipped device 2. The charging unit 23 is connected to a commercial power system 4 via an AC adapter (not shown). The AC adapter converts an AC voltage of 100/200 V input from the commercial power system 4 into a DC voltage of about 5 to 20 V and outputs the DC voltage.

The charging unit 23 includes a DC/DC converter. The DC/DC converter (for example, a switching regulator) controls a voltage or a current of the DC power supplied from the AC adapter in accordance with a voltage command value or a current command value supplied from the control unit 21, and outputs the DC power of the voltage or the current designated by the command value to at least one of the load unit 22 and the battery pack 30.

The battery pack 30 includes an assembled battery system 31 and a battery management device 32. The assembled battery system 31 includes a plurality of single cells connected in series or a plurality of parallel cell groups connected in series.

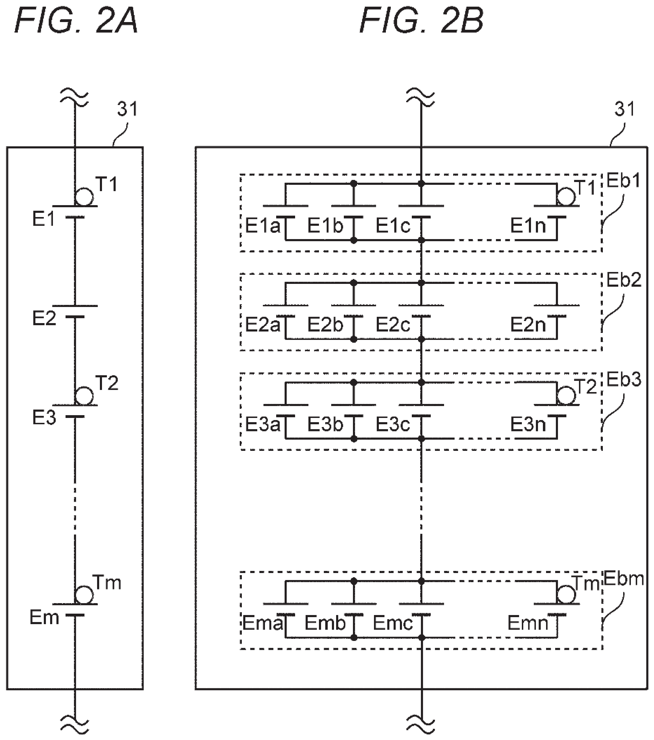

FIG. 2A is a diagram showing a configuration of an assembled battery system 31 including a plurality of single cells E1 to Em connected in series. FIG. 2B is a diagram showing a configuration of an assembled battery system 31 including a plurality of parallel cell groups Eb1 to Ebm connected in series. Each of the parallel cell groups Eb1 to Ebm includes a plurality of single cells (E1a to E1n) to (Ema to Emn) connected in parallel.

As the cell, a lithium-ion battery cell, a nickel-metal hydride battery cell, a lead-acid battery cell, or the like can be used. Hereinafter, in the present specification, an example in which a lithium-ion battery cell (nominal voltage: 3.6 to 3.7 V) is used is assumed. The number of single cells or parallel cell groups connected in series is determined according to the voltage of the load unit 22.

A switch SW1 that switches between conduction and non-conduction with the load unit 22 or the charging unit 23 is inserted into a power line that connects the assembled battery system 31 and the load unit 22 or the charging unit 23. A semiconductor switch or a relay can be used as the switch SW1.

Battery management device 32 includes a measurement unit 33, a control unit 34, and a nonvolatile storage unit 35. The measurement unit 33 is constituted by an AFE (Analog Front End) IC or an ASIC (Application Specific Integrated Circuit). The control unit 34 is constituted by a microcontroller. The control unit 34 includes an acquisition unit 341 and a determination unit 342. The nonvolatile storage unit 35 is constituted by an EEPROM (Electrically Erasable Programmable Read Only Memory) or a NAND flash memory. When the microcontroller has an EEPROM built in, the nonvolatile storage unit 35 can be omitted.

The measurement unit 33 is connected to each node of the plurality of single cells E1 to Em or parallel cell groups Eb1 to Ebm connected in series by a plurality of voltage measurement lines, and measures the voltage between two adjacent voltage measurement lines to measure the voltage of each single cell E1 to Em or parallel cell group Eb1 to Ebm.

The measurement unit 33 includes a multiplexer and an A/D converter. The multiplexer outputs the voltages of the plurality of single cells E1 to Em or parallel cell groups Eb1 to Ebm to the A/D converter in a predetermined order. The A/D converter converts an analog voltage input from the multiplexer into a digital value. The measurement unit 33 transmits the voltage value of each of the single cells E1 to Em or parallel cell groups Eb1 to Ebm converted into the digital value to the control unit 34 via the serial communication interface.

The measurement unit 33 measures a current flowing through the assembled battery system 31. A shunt resistor Rs is connected to a power line connecting the assembled battery system 31 and the load unit 22 or the charging unit 23. The differential amplifier (not shown) amplifies the voltage across the shunt resistor Rs and outputs the amplified voltage to the A/D converter in the measurement unit 33. The A/D converter converts an analog voltage indicating a current flowing through the assembled battery system 31 input from the differential amplifier into a digital value. The measurement unit 33 transmits the current value converted into the digital value to the control unit 34 via the serial communication interface.

A plurality of temperature sensors T1 to Tm (for example, thermistors) are installed on the surface of the assembled battery system 31. A divided voltage of each temperature sensor T1 to Tm and a voltage dividing resistor (not shown) is input to the measurement unit 33. The A/D converter in the measurement unit 33 converts an input analog voltage indicating the temperature detected by each of the temperature sensors T1 to Tm into a digital value. The measurement unit 33 transmits the temperature values detected by the temperature sensors T1 to Tm, which have been converted into digital values, to the control unit 34 via the serial communication interface.

The control unit 34 manages the state of each of the single cells E1 to Em or parallel cell groups Eb1 to Ebm based on the voltage value of each of the single cells E1 to Em or parallel cell groups Eb1 to Ebm received from the measurement unit 33, the value of the current flowing through the assembled battery system 31, and the temperature value detected by each of the temperature sensors T1 to Tm. When detecting any one of overcharge, overdischarge, overcurrent, high-temperature abnormality, and low-temperature abnormality, the control unit 34 transmits a cutoff signal of the switch SW1 to the measurement unit 33 to turn off the switch SW1.

The control unit 34 realizes the following functions by executing a program such as firmware in the microcontroller. The control unit 34 estimates the SOC by combining the OCV method and the coulomb counting method. The OCV method is a method of estimating the SOC based on the measured OCV of the cell and the SOC-OCV curve of the cell. The SOC-OCV curve of the cell is created in advance based on a characteristic test by a battery manufacturer, and is registered in the control unit 34 at the time of shipment.

The coulomb counting method is a method of estimating the SOC based on the OCV at the start of charge and discharge of the cell and the integrated value of the measured current. In the coulomb counting method, as the charge/discharge time becomes longer, current measurement errors are accumulated. Therefore, it is preferable to use a weighted average of the SOC estimated by the coulomb counting method and the SOC estimated by the OCV method.

In the first embodiment, a battery abnormality detection system is implemented in the control unit 34 of the battery management device 32. The acquisition unit 341 records the voltages of the plurality of single cells E1 to Em or parallel cell groups Eb1 to Ebm in a state where the assembled battery system 31 is charged to the target voltage, which are acquired from the measurement unit 33, in the nonvolatile storage unit 35. The voltages of the plurality of single cells E1 to Em or parallel cell groups Eb1 to Ebm in a state where one of the single cells or parallel cell groups is charged to the target voltage may be recorded instead of the state where the assembled battery system 31 is charged to the target voltage.

The target voltage may be a target voltage during CV charging in CC-CV charging. Specifically, the target voltage may be a full charge voltage (voltage when SOC = 100%) or may be a specified voltage of SOC 50% or more. There is a vehicle type in which, in the case of a hybrid car, the specified voltage is set to 50% in order to secure a capacity for receiving regenerative charging. In addition, there is a vehicle type in which even a pure EV can be charged to only 95% in order to prevent overcharge.

An object of the present embodiment is to detect a micro short circuit of a cell. When a voltage drop due to a short circuit from a high voltage state is compared with a voltage drop due to a short circuit from a low voltage state, a short circuit current flows more easily as the voltage is higher. Therefore, the degree of the voltage drop tends to decrease in the latter case. Therefore, it is desirable to detect a short circuit using data in a state of a voltage as high as possible, and it is desirable that the above-described target voltage is a voltage of at least SOC 50% or more.

The acquisition unit 341 acquires the time-series data of the voltages of the plurality of single cells E1 to Em or parallel cell groups Eb1 to Ebm in a state of being charged to the target voltage from the nonvolatile storage unit 35 at a predetermined short-circuit determination timing. The predetermined short-circuit determination timing may be a charge completion timing at which the assembled battery system is charged to the target voltage.

The determination unit 342 determines a single cell or a parallel cell group (hereinafter, a single cell and a parallel cell group are collectively referred to as a cell as appropriate) in which the acquired voltage in a state of being charged to the target voltage shows a downward trend as a cell in which a micro short circuit has occurred. Hereinafter, a specific example will be described.

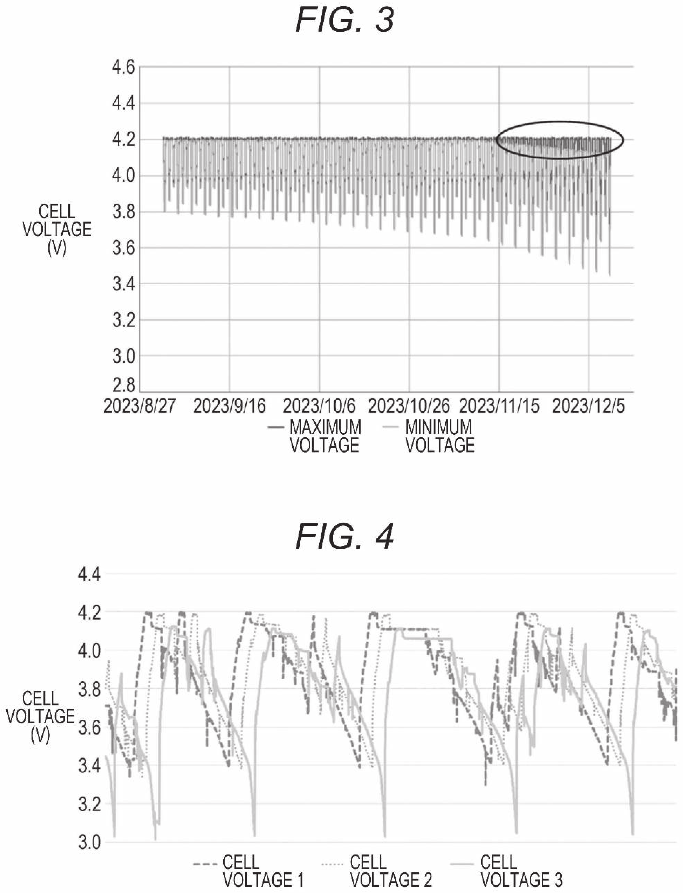

FIG. 3 is a diagram showing an example of transition data of the maximum cell voltage and the minimum cell voltage in the assembled battery system 31. The maximum cell voltage and the minimum cell voltage upon reaching full charge in the section before the circled section substantially coincide with each other, and it is estimated that there is no micro-short-circuited cell. On the other hand, the voltage difference between the maximum cell voltage and the minimum cell voltage upon reaching full charge in the circled section gradually increases, and it is estimated that the cell having the minimum voltage is micro-short-circuited.

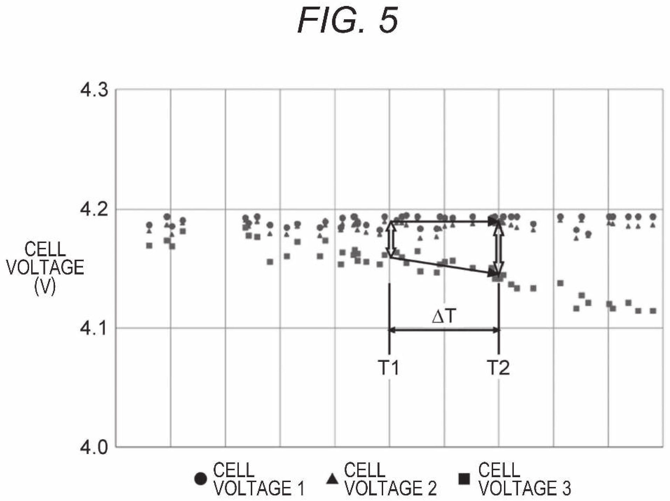

FIG. 4 is a diagram showing an example of transition data of the voltage of each cell after occurrence of a micro short circuit in the assembled battery system 31 having three cells connected in series. FIG. 5 is a diagram showing the cell voltage upon reaching full charge, which is extracted from the transition data of the cell voltage shown in FIG. 4. The three cell voltages shown in FIG. 4 are shifted by a predetermined time for each cell in order to avoid overlapping of transition lines. The example shown in FIGS. 4 and 5 shows a case where a micro short circuit occurs in the third cell E3.

The determination unit 342 determines the presence or absence of a micro short circuit in each cell based on the voltage of each cell in a predetermined interval ΔT (time T1 to time T2) shown in FIG. 5. For example, the determination unit 342 determines that a cell in which the voltage upon reaching full charge continuously shows a downward trend a predetermined number of times or more is a cell in which a micro short circuit has occurred. The determination unit 342 may determine that a cell in which the voltage upon reaching full charge continuously shows a downward trend a predetermined number of times or more in relative comparison with other cells is a cell in which a micro short circuit has occurred. Here, the cell that shows a downward trend in the relative comparison with the other cells refers to a cell in which a difference in the downward direction with respect to a representative value (for example, an average value or a median value) of the voltages of the plurality of cells E1 to E3 connected in series increases.

In addition, the determination unit 342 may perform linear regression on the voltage upon reaching full charge for each of the plurality of cells E1 to E3, and determine a cell in which the slope deviates by a predetermined value or more in the negative direction from the slope of a straight line having a slope = 0 or the slope of the regression line of another cell as a cell in which a micro short circuit has occurred. In FIG. 5, the slope of the regression line of the voltage of the first cell E1 in the predetermined interval ΔT is substantially horizontal (substantially 0), and the slope of the regression line of the voltage of the second cell E2 in the predetermined interval ΔT is also substantially horizontal (substantially 0). On the other hand, the slope of the regression line of the voltage of the third cell E3 in the predetermined interval ΔT is a negative value descending to the right. Therefore, it is determined that the third cell E3 is micro-short-circuited.

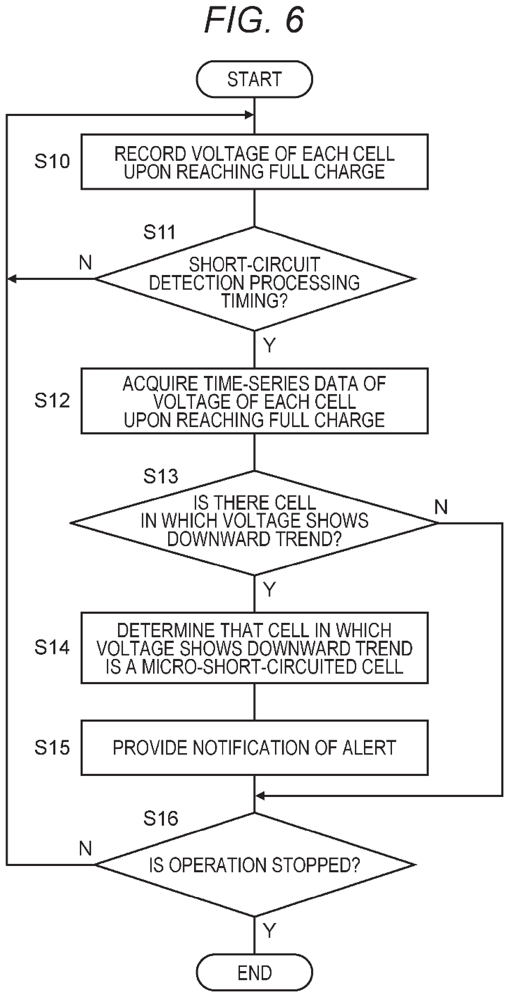

FIG. 6 is a flowchart illustrating a flow of battery abnormality detection processing by the battery management device 32 according to the first embodiment. The acquisition unit 341 records the voltage of each cell upon reaching full charge, which is acquired from the measurement unit 33, in the nonvolatile storage unit 35 (S10). When the short-circuit detection processing timing arrives (Y in S11), the acquisition unit 341 acquires the time-series data of the voltage of each cell upon reaching full charge from the nonvolatile storage unit 35 (S12).

The determination unit 342 determines the presence or absence of a cell in which the voltage shows a downward trend (S13). When there is a cell in which the voltage shows a downward trend (Y in S13), the determination unit 342 determines that the cell is a micro-short-circuited cell (S14). The determination unit 342 notifies the user of an alert by turning on a warning lamp (not shown) or the like (S15). When there is no cell in which the voltage shows a downward trend (N in S13), the processes of steps S14 and S15 are skipped. The processes of steps S10 to S15 described above are repeatedly executed (N in S16) until the operation of the battery pack 30 is stopped (Y in S16).

As described above, according to the first embodiment, a micro short circuit of a cell can be detected at an early stage with high accuracy. That is, because it is less susceptible to inter-cell voltage variation, and smoothing is not required, false detection can be reduced. In addition, even when a micro short circuit occurs in a cell having a relatively high voltage, the micro short circuit can be detected at an early stage.

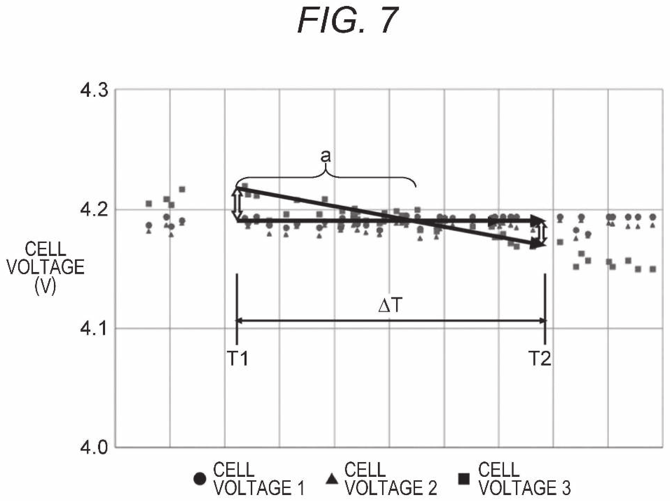

FIG. 7 is a diagram illustrating another example of the cell voltage upon reaching full charge, which is extracted from the transition data of the voltage of each cell after the occurrence of the micro short circuit in the assembled battery system 31 having three cells connected in series. The example shown in FIG. 7 also shows a case where a micro short circuit occurs in the third cell E3, but unlike the example shown in FIG. 5, a micro short circuit occurs in a state where the voltage of the third cell E3 is relatively higher than those of the other cells E1 and E2. In this case, in the section 'a' immediately after the occurrence of the micro short circuit, the voltage difference between the maximum cell voltage and the minimum cell voltage shifts in the decreasing direction.

In the method of determining the occurrence of a micro short circuit when the voltage difference between cells increases according to the related art, it takes time to detect a micro short circuit. On the other hand, in the present embodiment, since a micro short circuit is detected on the basis that the cell voltage shows a downward trend, it is possible to detect the micro short circuit at an early stage.

Further, according to the present embodiment, it is only necessary to record the voltage data when charged to the target voltage. Therefore, the amount of data to be recorded can be significantly reduced as compared with a method in which it is necessary to record the voltage data of the entire period. Therefore, the nonvolatile storage unit 35 having a relatively low capacity can be used, and the introduction cost can be suppressed. Further, by using only the voltage data when charged to the target voltage, it is possible to eliminate the influence of variations in the cell voltage during charging and discharging.

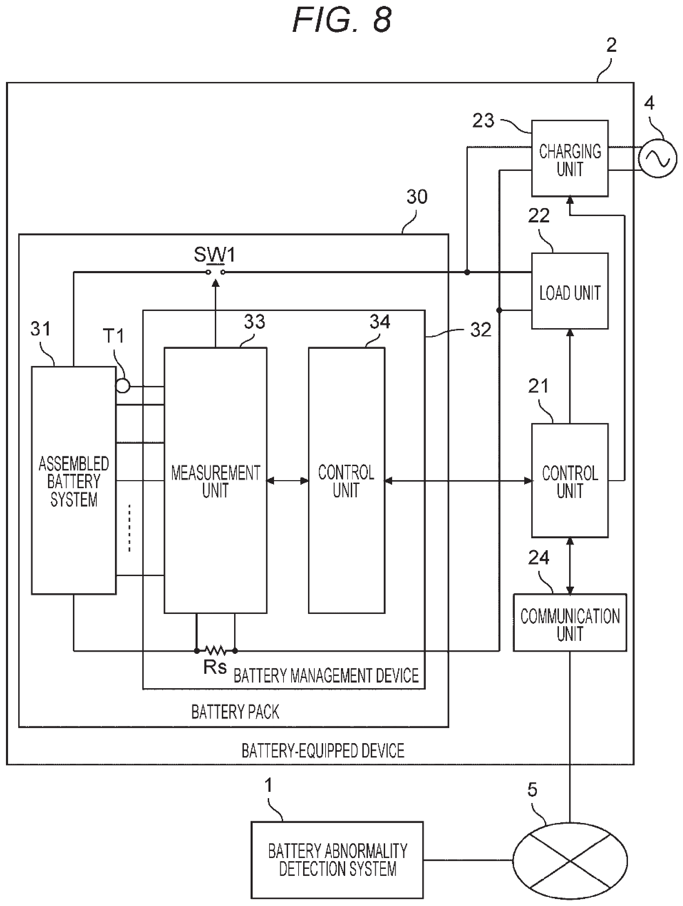

FIG. 8 is a diagram for explaining a battery-equipped device 2 according to the second embodiment. In the first embodiment, an example in which the battery abnormality detection system is mounted on the battery management device 32 has been described. In contrast, in the second embodiment, an example in which a battery abnormality detection system is implemented in a cloud server will be described.

In the battery-equipped device 2 according to the second embodiment, the nonvolatile storage unit 35 for recording the voltage data when the target voltage is reached can be omitted. In the battery-equipped device 2 according to the second embodiment, a communication unit 24 is added. The communication unit 24 is an external communication interface (for example, a network interface card (NIC)) for connecting to the external network 5 in a wired or wireless manner.

The control unit 34 transmits battery data including the voltage of each cell, current, temperature, and SOC of the assembled battery system 31 to the control unit 21 via a network inside the device. The control unit 21 accesses the network 5 via the communication unit 24, and transmits the battery data received from the control unit 34 of the battery pack 30 to the battery abnormality detection system 1 at a predetermined transmission cycle (for example, a cycle of 10 seconds or a cycle of 1 minute).

The network 5 is a general term for communication paths such as the Internet, a dedicated line, and a virtual private network (VPN), and a communication medium and a protocol thereof do not matter. As the communication medium, for example, a wired LAN, a wireless LAN, a mobile phone network, an optical fiber network, an ADSL network, a CATV network, or the like can be used. As the communication protocol, for example, TCP (Transmission Control Protocol)/IP (Internet Protocol), UDP (User Datagram Protocol)/IP, Ethernet (registered trademark), or the like can be used.

The battery abnormality detection system 1 is a system for estimating and analyzing the state of the battery pack 30 mounted in the battery-equipped device 2. In the second embodiment, the battery abnormality detection system 1 is constructed on a cloud server installed in a data center managed by a cloud service provider. A battery analysis service provider that provides the analysis service of the battery pack 30 uses the cloud server by making a contract with the cloud service provider. The battery abnormality detection system 1 may be constructed on an in-house server installed in its own facility or a data center of a battery analysis service provider.

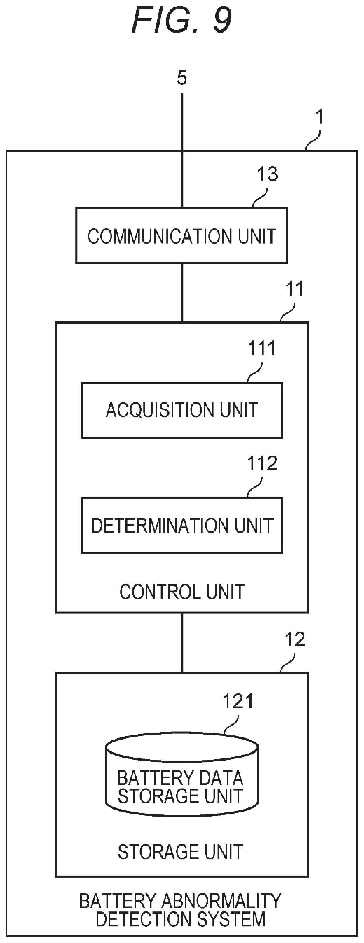

FIG. 9 is a diagram illustrating a configuration example of the battery abnormality detection system 1 according to the second embodiment. The battery abnormality detection system 1 includes a control unit 11, a storage unit 12, and a communication unit 13. The communication unit 13 is an external communication interface for connecting to the network 5 in a wired or wireless manner.

The control unit 11 includes an acquisition unit 111 and a determination unit 112. The function of the control unit 11 can be realized by cooperation of hardware resources and software resources or only hardware resources. As hardware resources, a CPU, a ROM, a RAM, a GPU, an NPU, an ASIC, an FPGA, and other LSIs can be used. Programs such as an operating system and applications can be used as software resources.

The storage unit 12 includes a nonvolatile recording medium such as an HDD or an SSD, and stores various types of data. The storage unit 12 includes a battery data storage unit 121. The acquisition unit 111 acquires the battery data of the battery pack 30 mounted on the battery-equipped device 2 from the battery-equipped device 2 via the network 5. The acquisition unit 111 stores the acquired battery data in the battery data storage unit 121. Other functions of the acquisition unit 111 and the determination unit 112 are similar to the functions of the acquisition unit 341 and the determination unit 342 of the control unit 34 of the battery management device 32 according to the first embodiment.

As described above, according to the second embodiment, the same effects as those of the first embodiment are achieved. Further, according to the second embodiment, the battery abnormality detection processing according to the present disclosure can be applied even to the battery pack 30 equipped with the existing battery management device 32 in which the battery abnormality detection system according to the present disclosure is not mounted. In addition, short circuit detection can be added to one of comprehensive battery analysis services including life prediction and the like using a cloud service.

The present disclosure has been described above based on the embodiments. The embodiment is intended to be illustrative only and it will be obvious to those skilled in the art that various modifications to constituent elements and processes could be developed and that such modifications are also within the scope of the present disclosure.

In the embodiment described above, a processing example has been described in which the determination unit 342 determines a cell in which the voltage upon reaching full charge continuously shows a downward trend a predetermined number of times or more as a cell in which a micro short circuit has occurred. The determination unit 342 may adaptively switch the predetermined number of times according to the charging frequency to the target voltage. Specifically, as the charging frequency to the target voltage is lower, the predetermined number of times is reduced. For example, in the case of the battery-equipped device 2 in which the charging frequency to the target voltage is once a week, the predetermined number of times may be set to three. When the battery-equipped device 2 is charged to the target voltage every day, the predetermined number of times may be set to 10.

The exemplary embodiment may be specified by the following items.

[Item 1] A battery abnormality detection system (34) for detecting an abnormality of an assembled battery system (31) including a plurality of single cells (E1-Em) connected in series or a plurality of parallel cell groups (Eb1-Ebm) connected in series, comprising: an acquisition unit (341) that acquires time-series data of voltage of the plurality of single cells (E1-Em) or the plurality of parallel cell groups (Eb1-Ebm) when the assembled battery system (31) is in a state of being charged to a target voltage or when any one of the plurality of single cells (E1-Em) or any one of the plurality of parallel cell groups (Eb1-Ebm) is in a state of being charged to the target voltage; and a determination unit (342) that determines that a micro short circuit has occurred in a single cell or a parallel cell group of which the acquired voltage when in the state of being charged to the target voltage shows a downward trend, the single cell being one of the plurality of single cells (E1-Em), the parallel cell group being one of the plurality of parallel cell groups (Eb1-Ebm).

According to this configuration, a micro short circuit in a single cell (E1-Em) or a parallel cell group (Eb1-Ebm) can be detected early with high accuracy.

[Item 2] The battery abnormality detection system (34) according to Item 1, wherein the determination unit (342) determines that the micro short circuit has occurred in the single cell or the parallel cell group of which the voltage when in the state of being charged to the target voltage shows the downward trend a predetermined number of times or more consecutively.

According to this, a micro short circuit can be detected with high accuracy.

[Item 3] The battery abnormality detection system (34) according to Item 1, wherein the determination unit (342) performs linear regression, for each of the plurality of single cells or the plurality of parallel cell groups, on the voltage when in the state of being charged to the target voltage, and determines that the micro short circuit has occurred in the single cell or the parallel cell group whose slope deviates in a negative direction by a predetermined value or more.

According to this, a micro short circuit can be detected with high accuracy.

[Item 4] The battery abnormality detection system (34) according to any one of Items 1 to 3, wherein the determination unit determines, through relative comparison with another single cell or another parallel cell group, that the micro short circuit has occurred.

According to this, a micro short circuit can be detected with high accuracy.

[Item 5] The battery abnormality detection system (34) according to any one of Items 1 to 3, wherein the target voltage is a full-charge voltage.

According to this, by using the voltage data in the state of being fully charged, the influence of the micro short circuit can be more accurately grasped.

[Item 6] A battery abnormality detection method for detecting an abnormality of an assembled battery system (31) including a plurality of single cells (E1-Em) connected in series or a plurality of parallel cell groups (Eb1-Ebm) connected in series, comprising: acquiring time-series data of voltage of the plurality of single cells (E1-Em) or the plurality of parallel cell groups (Eb1-Ebm) when the assembled battery system (31) is in a state of being charged to a target voltage or when any one of the plurality of single cells (E1-Em) or any one of the plurality of parallel cell groups (Eb1-Ebm) is in the state of being charged to the target voltage; and determining that a micro short circuit has occurred in a single cell or a parallel cell group of which the acquired voltage when in the state of being charged to the target voltage shows a downward trend, the single cell being one of the plurality of single cells (E1-Em), the parallel cell group being one of the plurality of parallel cell groups (Eb1-Ebm).

According to this configuration, a micro short circuit in a single cell (E1-Em) or a parallel cell group (Eb1-Ebm) can be detected early with high accuracy.

[Item 7] A battery abnormality detection program for detecting an abnormality of an assembled battery system (31) including a plurality of single cells (E1-Em) connected in series or a plurality of parallel cell groups (Eb1-Ebm) connected in series, the battery abnormality detection program comprising instructions which, when the program is executed by a computer, cause the computer to carry out the steps of: acquiring time-series data of voltage of the plurality of single cells (E1-Em) or the plurality of parallel cell groups (Eb1-Ebm) when the assembled battery system (31) is in a state of being charged to a target voltage or when any one of the plurality of single cells (E1-Em) or any one of the plurality of parallel cell groups (Eb1-Ebm) is in the state of being charged to the target voltage; and determining that a micro short circuit has occurred in a single cell or a parallel cell group of which the acquired voltage when in the state of being charged to the target voltage shows a downward trend, the single cell being one of the plurality of single cells (E1-Em), the parallel cell group being one of the plurality of parallel cell groups (Eb1-Ebm).

According to this configuration, a micro short circuit in a single cell (E1-Em) or a parallel cell group (Eb1-Ebm) can be detected early with high accuracy.

### Reference Signs List

- 1: battery abnormality detection system
- 2: battery-equipped device
- 4: commercial power system
- 5: network
- 21: control unit
- 22: load unit
- 23: charging unit
- 24: communication unit
- 30: battery pack
- 31: assembled battery system
- 32: battery management device
- 33: measurement unit
- 34: control unit
- 341: acquisition unit
- 342: determination unit
- 35: nonvolatile storage unit
- E1-Em: cell
- Rs: shunt resistor
- SW1: switch
- 11: control unit
- 111: acquisition unit
- 112: determination unit
- 12: storage unit
- 121: battery data storage unit
- 13: communication unit

## Claims

1. A battery abnormality detection system for detecting an abnormality of an assembled battery system including a plurality of single cells connected in series or a plurality of parallel cell groups connected in series, comprising:
an acquisition unit that acquires time-series data of voltage of the plurality of single cells or the plurality of parallel cell groups when the assembled battery system is in a state of being charged to a target voltage or when any one of the plurality of single cells or any one of the plurality of parallel cell groups is in a state of being charged to the target voltage; and
a determination unit that determines that a micro short circuit has occurred in a single cell or a parallel cell group of which the voltage when in the state of being charged to the target voltage shows a downward trend, the single cell being one of the plurality of single cells, the parallel cell group being one of the plurality of parallel cell groups.

2. The battery abnormality detection system according to claim 1,
wherein the determination unit determines that the micro short circuit has occurred in the single cell or the parallel cell group of which the voltage when in the state of being charged to the target voltage shows the downward trend a predetermined number of times or more consecutively.

3. The battery abnormality detection system according to claim 1,
wherein the determination unit performs linear regression, for each of the plurality of single cells or the plurality of parallel cell groups, on the voltage when in the state of being charged to the target voltage, and determines that the micro short circuit has occurred in the single cell or the parallel cell group whose slope deviates in a negative direction by a predetermined value or more.

4. The battery abnormality detection system according to any one of claims 1 to 3,
wherein the determination unit determines, through relative comparison with another single cell or another parallel cell group, that the micro short circuit has occurred.

5. The battery abnormality detection system according to any one of claims 1 to 3,
wherein the target voltage is a full-charge voltage.

6. A battery abnormality detection method for detecting an abnormality of an assembled battery system including a plurality of single cells connected in series or a plurality of parallel cell groups connected in series, comprising:
acquiring time-series data of voltage of the plurality of single cells or the plurality of parallel cell groups when the assembled battery system is in a state of being charged to a target voltage or when any one of the plurality of single cells or any one of the plurality of parallel cell groups is in the state of being charged to the target voltage; and
determining that a micro short circuit has occurred in a single cell or a parallel cell group of which the acquired voltage when in the state of being charged to the target voltage shows a downward trend, the single cell being one of the plurality of single cells, the parallel cell group being one of the plurality of parallel cell groups.

7. A battery abnormality detection program for detecting an abnormality of an assembled battery system including a plurality of single cells connected in series or a plurality of parallel cell groups connected in series, the battery abnormality detection program comprising instructions which, when the program is executed by a computer, cause the computer to carry out the steps of:
acquiring time-series data of voltage of the plurality of single cells or the plurality of parallel cell groups when the assembled battery system is in a state of being charged to a target voltage or when any one of the plurality of single cells or any one of the plurality of parallel cell groups is in the state of being charged to the target voltage; and
determining that a micro short circuit has occurred in a single cell or a parallel cell group of which the acquired voltage when in the state of being charged to the target voltage shows a downward trend, the single cell being one of the plurality of single cells, the parallel cell group being one of the plurality of parallel cell groups.
